# EUROPEAN PATENT APPLICATION

(11) **EP 4 242 335 A1**
(43) Date of publication of application: **13.09.2023**
(21) Application number: 21889205.7
(22) Date of filing: 02.11.2021
(51) Int. Cl.: C22C 30/00, C22C 1/04, B33Y 10/00, B33Y 80/00, B33Y 70/00, B22F 10/34, B22F 10/38, B22F 10/60

(54) **ALLOY MEMBER MANUFACTURING METHOD, ALLOY MEMBER, AND PRODUCT USING ALLOY MEMBER**

(30) Priority: 04.11.2020 JP 2020184125
(71) Applicant: Proterial, Ltd., Tokyo 135-0061 (JP)
(72) Inventor: KOSEKI, Shuho, Tokyo 108-8224 (JP); KUWABARA, Kousuke, Tokyo 108-8224 (JP); HONDA, Fumiaki, Tokyo 108-8224 (JP)
(74) Representative: Becker, Eberhard
(86) International application number: PCT/JP2021/040431
(87) International publication number: WO 2022/097652

(57) **Abstract**

Provided are a method for manufacturing an alloy member, and an alloy member, the alloy member having excellent mechanical properties and corrosion resistance, and further having abrasion resistance, and being manufactured by a laminated molding method using an alloy powder. The method for manufacturing an alloy member is characterized by having: a laminated molding step for forming an alloy substrate by means of a laminate shaping method using an alloy powder comprising, in an amount range of 5 atomic% to 35 atomic%, respectively, each element of Co, Cr, Fe, Ni, and Ti, and in an amount of 0 atomic% to 8 atomic% (exclusive of 0 atomic%) of Mo, with the balance being unavoidable impurities; and a surface treatment step for performing a surface treatment on the alloy substrate.

## Description

### [Technical Field]

The present invention relates to a method for manufacturing an alloy member produced by using an additive manufacturing method, an alloy member obtained by using this manufacturing method, and a product using the alloy member.

### [Background Art]

Recently, high-entropy alloys (HEAs) have been proposed as alloys of a new technical idea that have marked a milestone from the technical idea of the alloys of the related art (e.g., alloys obtained by adding a slight amount of multiple types of subcomponent elements to one to three types of major component elements). A HEA is defined as an alloy containing five or more types of major metal elements (each with a concentration of 5 to 35 atomic%) and known to exhibit the following characteristics. In addition, although the concept of an alloy that is a multi-principal element alloy (MPEA) that contains multiple major elements but allows the presence of multiple phases has also been proposed, HEAs and MPEAs are treated as of the same concept, and collectively referred to as HEAs in the present specification.

Features of a HEA include (a) stabilization of a mixed state resulting from negatively increasing a mixed entropy term in a Gibbs free energy formula, (b) a diffusion delay resulting from a complicated microstructure, (c) hardening due to a high lattice distortion caused by a difference in size of constituent atoms and deterioration of mechanical properties dependent on temperature, (d) improved corrosion resistance caused by combined effects (which is also called a cocktail effect) attributable to coexistence of multiple elements, and the like.

Here, Patent Literature 1 discloses an alloy member containing each element of Co, Cr, Fe, Ni, and Ti in the amount range of 5 atomic% to 35 atomic%, and Mo in the amount range of 0 atomic% to 8 atomic% (exclusive of 0 atomic%) in a chemical composition with the balance being unavoidable impurities, in which ultra-small particles with an average particle size of 100 nm or smaller are dispersed and precipitated in the parent-phase crystal grains.

According to Patent Literature 1, a predetermined heat treatment is performed on a molding member produced in a laminated molding method to obtain a microstructure in which nanoscale ultra-small particles are dispersed and precipitated in parent-phase crystal grains, and as a result, an alloy member with improvement in tensile strength, significant improvement in ductility, and improvement in corrosion resistance can be provided.

### [Citation List]

### [Patent Literature]

[Patent Literature 1] WO 2019/031577

### [Summary of Invention]

### [Technical Problem]

According to the technique of Patent Literature 1, an alloy member excellent in mechanical properties such as tensile strength and ductility and corrosion resistance can be obtained. However, in order to apply this alloy member to a severe environment in which abrasion resistance is required, further improvement in abrasion resistance is needed.

According to the above configuration, an objective of the present invention is to provide a method for manufacturing an alloy member that is produced in an additive manufacturing method using an alloy powder to have excellence in mechanical properties and corrosion resistance and further abrasion resistance, an alloy member, and a product using the alloy member.

### [Solution to Problem]

A method for manufacturing an alloy member of the present invention includes an additive manufacturing step for forming an alloy substrate using an additive manufacturing method using an alloy powder containing each element of Co, Cr, Fe, Ni, and Ti in an amount range of 5 atomic% to 35 atomic%, and Mo in an amount range of 0 atomic% to 8 atomic% (exclusive of 0 atomic%), with the balance being unavoidable impurities, and a surface treatment step for performing a surface treatment on the alloy substrate.

In addition, it is preferable to have an aging heat treatment step for holding the alloy substrate at a temperature in the range of 450°C to 1000°C (exclusive of 1000°C) between the additive manufacturing step and the surface treatment step.

In addition, it is preferable in the surface treatment step that the alloy substrate be subjected to a surface treatment while being held at a temperature in the range of 450°C to 1000°C (exclusive of 1000°C).

In addition, it is preferable in the additive manufacturing step that a heat source to be used in the additive manufacturing method be a laser beam or an electron beam.

An alloy member of the present invention includes an alloy substrate containing each element of Co, Cr, Fe, Ni, and Ti in an amount range of 5 atomic% to 35 atomic%, and Mo in an amount range of 0 atomic% to 8 atomic% (exclusive of 0 atomic%), with the balance being unavoidable impurities, and a surface-treated layer formed on a surface of the alloy substrate, in which a Rockwell hardness of the alloy substrate is equal to or higher than 38 HRC.

In addition, it is preferable for the alloy member to have a microcell structure with an average diameter of 10 µm or less at least in crystal grains of a surface layer, to have, on the boundary of the microcell structure, dislocations of higher surface density than that the inside of the structure, and to have ultra-fine particles with an average particle size of 50 nm or less dispersed and precipitated at least inside the microcell structure.

Furthermore, it is preferable that Ti be concentrated on the boundary of the microcell structure.

In addition, it is preferable that ultra-small particles with an average particle size of 100 nm or smaller be dispersed and precipitated in the parent-phase crystal grains inside the member inward from the surface layer.

In addition, the present invention is a product using the alloy member described above.

### [Advantageous Effects of Invention]

According to the present invention, a method for manufacturing an alloy member that is produced in an additive manufacturing method using alloy powder and has excellent mechanical properties and corrosion resistance and further has abrasion resistance, an alloy member, and a product using the alloy member can be provided.

### [Brief Description of Drawings]

FIG. 1 is a step diagram illustrating an example of a method for manufacturing an alloy member according to the present invention.
FIG. 2 is a schematic cross-sectional diagram illustrating an example of a configuration of an additive manufacturing apparatus for a selective melting method and an additive manufacturing method.
FIG. 3 is a schematic cross-sectional diagram illustrating an example of a configuration of an additive manufacturing apparatus for a laser beam powder overlay method and an additive manufacturing method.
FIG. 4 is a graph showing an example of an aging heat treatment step after an additive manufacturing step.
FIG. 5 shows an example of a microstructure of a first alloy member according to the present invention in which (a) and (b) are scanning electron microscope images (SEM images) and (c) and (d) are scanning transmission electron microscope images (STEM images).
FIG. 6 shows an example of a microstructure of an alloy member according to a comparative example, in which (a) is a scanning electron microscope image (SEM image) and (b) is a scanning transmission electron microscope image (STEM image).
FIG. 7 is a step diagram illustrating another example of the method for manufacturing the alloy member according to the present invention.
FIG. 8 is a step diagram illustrating another example of the method for manufacturing the alloy member according to the present invention.
FIG. 9 is a schematic diagram illustrating an example of a cross-sectional diagram of the alloy member according to the present invention.
FIG. 10 is a schematic diagram illustrating an example of a cross-sectional diagram of the microstructure of a second alloy member (an alloy substrate C or an alloy substrate D) according to the present invention.
FIG. 11 is a graph showing an example of the hardness of the alloy member that has undergone an aging heat treatment.

### [Description of Embodiments]

First, the present inventors and the like have continuously conducted intensive research on an alloy composition and a shape control method in order to develop a high-entropy alloy member that is excellent in shape controllability and ductility, without sacrificing characteristics thereof as a high-entropy alloy (HEA). As a result, they were able to form an additive manufacturing member (alloy substrate) in an additive manufacturing method using powder of a Co-Cr-Fe-Ni-Ti-Mo-based alloy, and thus able to obtain an alloy member having favorable shape controllability and excellent tensile strength, ductility, and corrosion resistance, compared to a HEA member formed from ordinary forging of the related art. In other words, a microstructure in which extremely fine particles with an average particle size of 100 nm or smaller are dispersed and precipitated was formed by performing a solution heat treatment at a temperature in the range of 1080°C to 1180°C, and it was found that tensile strength and ductility were significantly improved together due to the microstructure.

Specifically, it has been found that a near-net-shaped alloy member was obtained and the alloy member has favorable mechanical properties (e.g., a tensile strength of 1100 MPa or greater and an elongation at break of 10% or higher). In addition, it has been found that the alloy member exhibits a high pitting corrosion generation potential and excellent corrosion resistance. However, as a result of performing an abrasion resistance test on machinery using the alloy member, it has been found that greater improvement in abrasion resistance under severe conditions such as against a sliding part, that is, enhancement in hardness, was desired. An alloy member in the present invention refers to a metal additive manufacturing member produced using an additive manufacturing method, and may be simply referred to as an alloy substrate.

Thus, the present inventors and the like have continuously conducted investigation and research on the relationship between the microstructure and properties of the alloy member derived from a manufacturing method. As a result, the present inventors have conceived a configuration in which a surface treatment is performed on a surface of an additive manufactured member (which will be referred to as an alloy substrate A below) as it is manufactured (a state in which a solidified structure is present at least on a surface layer), without requiring a solution heat treatment at a temperature in the range of 1080°C to 1180°C. This is the basic idea common in the present invention. With the above-described configuration, in a first embodiment of a method for manufacturing an alloy member of the present invention, (i) an alloy substrate A is obtained using an additive manufacturing method using alloy powder containing each element of Co, Cr, Fe, Ni, and Ti in the amount range of 5 atomic% to 35 atomic%, containing Mo in the amount range of 0 atomic% to 8 atomic% (exclusive of 0 atomic%), with the balance being unavoidable impurities, and the alloy substrate A is subjected to a surface treatment. A surface of the alloy substrate is subjected to a surface treatment as it is additive-manufactured, for example, without requiring a solution heat treatment step, and thus the hardness of the alloy substrate is improved. This alloy member has excellent mechanical properties such as high tensile strength and ductility and excellent corrosion resistance compared to an alloy member of the related art, further has improved hardness, and particularly, has abrasion resistance suitable for necessary applications. These are features different from that of Patent Literature 1.

Although the first embodiment is as described above, there is a mode in which a new melting/solidification step is additionally performed on a pre-obtained manufacturing substrate (alloy substrate) as another manufacturing method, (ii) As a second embodiment, a solution heat treatment in which a temperature is kept at a temperature in the range of 1080°C to 1180°C is performed on a pre-obtained alloy substrate A. Thus, a structure in which ultra-small particles with an average particle size of 100 nm or smaller are dispersed and precipitated in parent-phase crystal grains is formed, and an alloy substrate B with improved mechanical properties is obtained. Then, an alloy substrate C is obtained by melting and solidifying the surface layer of the alloy substrate B again using a laser beam, or the like (which may be referred to as a re-melting alloy substrate C). Then, a surface-treated layer is formed on the alloy substrate C at least with the surface layer having a solidified structure. The parent phase mentioned in the present specification is a phase of the original structure, and a phase not containing precipitates (or a precipitated structure).

At this time, the aging heat treatment is performed before a surface-treated layer is formed by performing a surface treatment on the alloy substrate C, and in the additive manufacturing step, it is preferable that ultra-fine particles with an average particle size of 50 nm or less that is smaller than ultra-small particles in parent-phase crystal grains be dispersed and precipitated in a cellular region (which is called a microcell structure in the present invention) with an average diameter of 10 µm or less that is finely divided by a network of dislocations having a higher density than the surroundings generated inside crystal grains composed of columnar crystals of the surface layer to impart hardness. Thus, according to this embodiment, more improved mechanical properties can be obtained and an alloy member with improved hardness in the surface layer can be obtained, in addition to the first embodiment. Furthermore, when a surface treatment is performed on the surface of the alloy substrate C, it is preferable to keep the alloy substrate C at a temperature in the range of 450°C to lower than 1000°C.

(iii) As a third embodiment, an additive manufacturing method (re-additive manufacturing step) is applied to the pre-obtained alloy substrate B using the method described in (ii) above to obtain an alloy substrate D obtained by forming a new melt/solidified layer on the surface layer of the alloy substrate B (which may be referred to as a surface layer-added alloy substrate D below). Then, a surface treatment is performed on the alloy substrate D to form a surface-treated layer. In addition, when a surface treatment is performed on the surface of the alloy substrate D, it is preferable to keep the alloy substrate D at a temperature in the range over 100°C to lower than 950°C.

When an aging heat treatment is performed on the alloy substrate D before forming the surface-treated layer from a surface treatment, ultra-fine particles with an average particle size of 50 nm or less that is smaller than that of ultra-small particles contained in the parent-phase crystal grains are dispersed and precipitated in the microcell structure of the surface layer to give hardness. Thus, more improved mechanical properties can be obtained and an alloy member with improved hardness in the surface layer can be obtained also in this embodiment.

The manufacturing methods described in (ii) and (iii) above are selectively performing an additional melting/solidification step on the pre-obtained (manufactured) alloy substrate. The (ii) re-melting alloy substrate C of the second embodiment and the (iii) surface layer-added alloy substrate D of the third embodiment have something in common with the alloy substrate A in that they have a solidified structure at least with the surface layer having a microcell structure, a solution treatment (solution heat treatment) is not required, and a surface-treated layer is formed on the surface. According to these manufacturing methods, an alloy member can be selectively manufactured in accordance with applications including an application that only requires abrasion resistance as well as an application that requires mechanical properties in addition to abrasion resistance. Thus, the number of production steps can be reduced and product variations become wider, which are advantageous to production control.

In addition, improvements and modifications can be applied to the above-described manufacturing methods for an alloy substrate as follows. (iv) Laser beams or electron beams can be used as a heat source to be used in the additive manufacturing method in the additive manufacturing step and re-additive manufacturing step. Thus, additive manufacturing under an inert gas atmosphere or in a vacuum can also be performed, which leads to a reduction in amount of impurities incorporated into the alloy member that may be caused by an oxygen or nitrogen atmosphere, or the like. (v) As a material supply method of the additive manufacturing method in the additive manufacturing step and re-additive manufacturing step, a supply method using a powder bed and a direct metal deposition method of squirting powder directly to a melted part, for example, a laser beam powder overlay method can be used. Thus, the method can support both molding with an excellent degree of freedom in shaping based on the powder bed method and local molding based on the direct metal deposition method.

In addition, an alloy substrate in an alloy member of the present invention includes (vi) an alloy substrate containing each element of Co, Cr, Fe, Ni, and Ti in an amount range of 5 atomic% to 35 atomic%, and Mo in an amount range of 0 atomic% to 8 atomic% (exclusive of 0 atomic%), with a balance being unavoidable impurities, and a surface-treated layer formed on a surface of the alloy substrate, in which a Rockwell hardness of the alloy substrate is equal to or higher than 38 HRC. An alloy member described above is extraordinarily excellent in hardness and abrasion resistance.

In addition, it is preferable for the alloy member to have a microcell structure with an average diameter of 10 µm or less at least in crystal grains of the surface layer, to have, on the boundary of the microcell structure, a dislocation of higher surface density than the inside of the microcell structure, and to have ultra-fine particles with an average particle size of 50 nm or less dispersed and precipitated at least inside the microcell structure. Having such a structure further improves hardness.

Improvements and modifications can be applied to the above-described alloy member as follows. (vii) Ti is concentrated on the boundary of the parent-phase microcell structure. If Ti with a large atomic radius is concentrated, a lattice strain at an atomic level becomes greater than that of the surroundings, and thus dislocations can remain more stably. In addition, the effect of further thwarting dislocation movement as at least part of the concentrated Ti is transformed into ultra-fine particles or other intermetallic compounds in an aging heat treatment is expected, which is advantageous to increase hardness. (viii) The parent-phase crystal structure has at least one of a face-centered cubic structure or a simple cubic structure. Such a crystal structure is useful to impart ductility required in a matrix in terms of excellent deformability.

(ix) The alloy member has excellent hardness, and can have a Rockwell hardness of 38 HRC or higher. In particular, the alloy member according to the manufacturing methods (ii) and (iii) described above has a surface layer exhibiting a hardness over 38 HRC in the matrix having a tensile strength of 1100 MPa or higher and an elongation at break of 10% or higher. An elongation at break of 5% or higher and a tensile strength of 1500 MPa or higher are obtained also in the manufacturing method (i). The alloy member is superior in corrosion resistance to corrosion-resistant stainless steel. As described above, the alloy member has excellent mechanical properties and hardness as well as corrosion resistance in a severe environment.

An embodiment of the present invention will be described below in order from the manufacturing method with reference to the accompanying drawings. However, the present invention is not limited to the embodiments exemplified herein and can be appropriately combined and modified within the scope not departing from the technical idea of the invention.

### <Method for manufacturing alloy member>

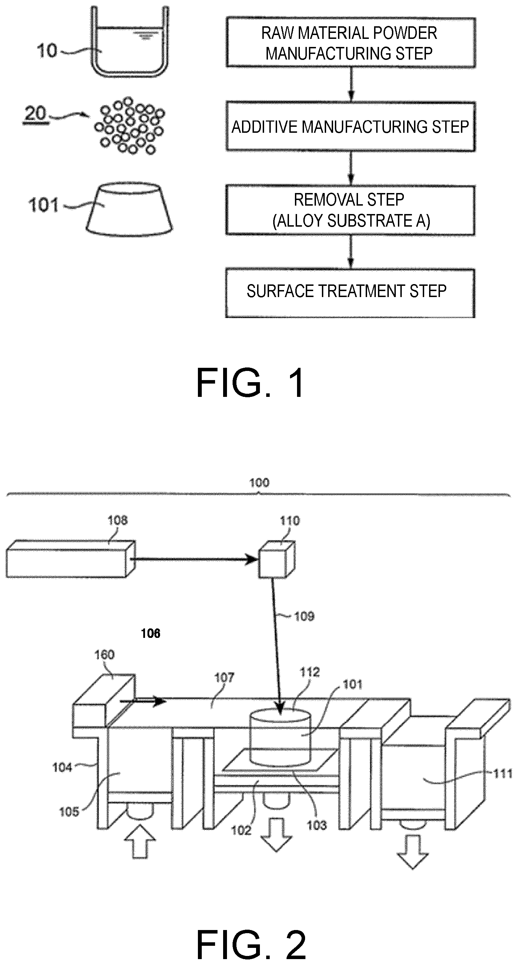

FIG. 1 is a step diagram illustrating an example of the method for manufacturing an alloy member according to an embodiment of the present invention. A method for manufacturing an alloy member of the present invention includes an additive manufacturing step for forming an alloy substrate using an additive manufacturing method using alloy powder containing each element of Co, Cr, Fe, Ni, and Ti in an amount range of 5 atomic% to 35 atomic%, and Mo in an amount range of 0 atomic% to 8 atomic% (exclusive of 0 atomic%), with a balance being unavoidable impurities, and a surface treatment step for performing a surface treatment on the alloy substrate. Next, the embodiment of the present invention will be described in detail for each step.

First, an alloy powder 20 having a desired HEA composition (Co-Cr-Fe-Ni-Ti-Mo) is prepared. The alloy powder 20 to be used can be obtained using, for example, an atomization method. An atomization method is not particularly limited, and an existing method can be used. For example, a gas atomization method (a vacuum gas atomization method, an electrode induction melting gas atomization method, etc.), a centrifugal atomization method, (a disc atomization method, a plasma-rotating electrode atomization method, etc.) a plasma atomization method, or the like can be preferably used.

### [Chemical composition]

The HEA composition of the present embodiment contains, as major components, five elements of Co, Cr, Fe, Ni, and Ti each in the amount range of 5 atomic% to 35 atomic%, and contains, as a sub component, Mo in the amount range of 0 atomic% to 8 atomic% (exclusive of 0 atomic%), with a balance being unavoidable impurities.

The chemical composition may contain the five elements of Co, Cr, Fe, Ni, and Ti each in the amount range of 5 atomic% to 35 atomic%, Mo in the amount range of 0 atomic% to 8 atomic% (exclusive of 0 atomic%), and B over 0 atomic%.

In addition, the chemical composition may contain Co in the amount range of 20 atomic% to 35 atomic%, Cr in the amount range of 10 atomic% to 25 atomic%, Fe in the amount range of 10 atomic% to 25 atomic%, Ni in the amount range of 15 atomic% to 30 atomic%, and Ti in the amount range of 5 atomic% to 15 atomic%.

In addition, the chemical composition may contain Co in the amount range of 25 atomic% to 33 atomic%, Cr in the amount range of 15 atomic% to 23 atomic%, Fe in the amount range of 15 atomic% to 23 atomic%, Ni in the amount range of 17 atomic% to 28 atomic%, Ti in the amount range of 5 atomic% to 10 atomic%, and Mo in the amount range of 1 atomic% to 7 atomic%.

In addition, the chemical composition may contain Co in the amount range of 25 atomic% to less than 30 atomic%, Cr in the amount range of 15 atomic% to less than 20 atomic%, Fe in the amount range of 15 atomic% to less than 20 atomic%, Ni in the amount range of 23 atomic% to 28 atomic%, Ti in the amount range of 7 atomic% to 10 atomic%, and Mo in the amount range of 1 atomic% to 7 atomic%.

In addition, the chemical composition may contain Co in the amount range of 30 atomic% to 33 atomic%, Cr in the amount range of 20 atomic% to 23 atomic%, Fe in the amount range of 20 atomic% to 23 atomic%, Ni in the amount range of 17 atomic% to less than 23 atomic%, Ti in the amount range of 5 atomic% to less than 7 atomic%, and Mo in the amount range of 1 atomic% to 3 atomic%. Control of the composition in the above composition range is more effective for compatibility of improvement in ductility and improvement in tensile strength.

If improvement in tensile strength is more prioritized, in the above composition range, Co in the amount range of 25 atomic% to less than 30 atomic% is more preferable, Cr in the amount range of 15 atomic% to less than 20 atomic% is more preferable, Fe in the amount range of 15 atomic% to less than 20 atomic% is more preferable, Ni in the amount range of 23 atomic% to 28 atomic% is more preferable, Ti in the amount range of 7 atomic% to 10 atomic% is more preferable, and Mo in the amount range of 1 atomic% to 7 atomic% is more preferable.

In addition, if improvement in ductility is more prioritized, in the above composition range, Co in the amount range of 30 atomic% to 33 atomic% is more preferable, Cr in the amount range of 20 atomic% to 23 atomic% is more preferable, Fe in the amount range of 20 atomic% to 23 atomic% is more preferable, Ni in the amount range of 17 atomic% to less than 23 atomic% is more preferable, Ti in the amount range of 5 atomic% to less than 7 atomic% is more preferable, and Mo in the amount range of 1 atomic% to 3 atomic% is more preferable.

### [Powder particle size]

An average particle size of the alloy powder 20 of the present embodiment is preferably 10 µm or more and 200 µm or less in terms of handling and filling properties. Furthermore, an appropriate average particle size varies depending on an additive manufacturing method, and it is preferably 10 µm or more and 50 µm or less in the selective laser melting (SLM) method, and 45 µm or more and 105 µm or less in the electron beam melting (EBM) method. In addition, it is preferably 50 µm or more and 150 µm or less in the directed energy deposition (DED) method or the laser metal deposition (LMD) method. If an average particle size is less than 10 µm, the alloy powder 20 is easily spread up in the additive manufacturing step that is the next step, which may cause deterioration in the shape accuracy of the alloy additive manufactured body. On the other hand, an average particle size over 200 µm may cause surface roughness of the additive manufactured body to increase in the additive manufacturing step that is the next step or cause the alloy powder 20 to insufficiently melt.

### (Additive manufacturing step)

Next, an additive manufacturing step to form an alloy additive manufactured body (referred to simply as an alloy substrate below) 101 in a desired shape is performed using a metal powder additive manufacturing method (referred to simply as an additive manufacturing method below) using the alloy powder 20 prepared as described above. With an application of the additive manufacturing method to mold an alloy member of a near-net shape through melting and solidification (referred to as melting/solidification) rather than sintering, an alloy substrate having a three-dimensional complicated shape as well as a hardness equal to or higher than that of a forged material can be produced. As the additive manufacturing method, an additive manufacturing method using SLM, EBM, LMD, or the like can be appropriately used as exemplified above.

As an example of the additive manufacturing method, the additive manufacturing step using the SLM will be described below.

FIG. 2 is a schematic diagram illustrating a configuration of a powder additive manufacturing apparatus of the SLM method 100. A stage 102 is lowered by the thickness of one layer (e.g., about 20 to 50 µm) of an alloy substrate 101 to be additive-manufactured. Alloy powder 105 is supplied from a powder supply container 104 onto a base plate 103 on the top surface of the stage 102, a recoater 106 is used to flatten the alloy powder 105, and thereby a powder bed 107 (layered powder) is formed.

Next, a laser beam 109 output from a laser oscillator 108 is radiated to the unmelted powder on the base plate 103 via a galvanometer mirror 110 based on 2D slice data converted from 3D-CAD data of the alloy substrate 101 to be manufactured, a micro molten pool is formed, and a 2D slice-shaped solidified layer 112 is formed by moving the micro molten pool and sequentially melting and solidifying the micro molten pool. The unmelted powder is recovered into an unmelted powder recovery container 111. Repetition of this operation to form the powder produces the alloy substrate 101.

### (Removal step)

The alloy substrate 101 is produced to be integrated with the base plate 103, and is covered with unmelted powder. At the time of removal, after the radiation of laser beams is finished and then the powder and the alloy substrate 101 are sufficiently cooled, the unmelted powder is recovered, and the alloy substrate 101 and the base plate 103 are removed from the powder additive manufacturing apparatus 100. Then, the alloy substrate 101 is cut out from the base plate 103 to obtain the alloy substrate 101 (corresponding to an alloy substrate A).

Here, a sample for observing an ultra-fine structure is collected from the removed alloy substrate 101, and then the ultra-fine structure of the sample is observed by using a scanning electron microscope. As a result, the parent phase of the alloy substrate 101 has a structure in which ultra-fine columnar crystals (with an average width of 50 µm or less) bristle in the manufactured direction of the alloy substrate 101 (so-called a rapid solidification structure). As a result of observing the sample in more details, a microcell structure with an average diameter of 10 µm or less is generated inside the ultra-fine columnar crystals. Here, a microcell structure indicates an oval or rectangular solidified structure that appears due to electrolytic etching, or the like using oxalic acid, or the like.

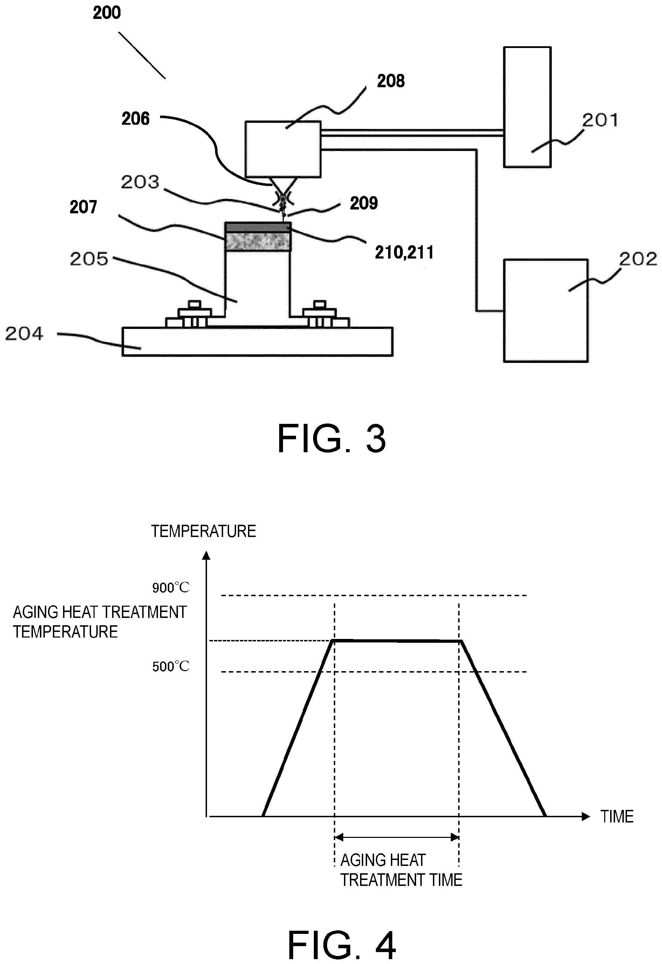

Next, an additive manufacturing step when the LMD method is used will be described. FIG. 3 is a schematic diagram illustrating a configuration of a powder additive manufacturing apparatus of the LMD method 200. The optical system is focused on the surface layer of the alloy substrate 211 to be additive-manufactured, and the alloy powder 105 is jet-supplied from the powder supply container 201 to the laser focus.

Concurrently, a laser beam or an electron beam 203 output from a laser oscillator 202 through a laser head 104 is radiated to an alloy substrate on a base plate 205 based on a radiation path converted from 3D-CAD data of the alloy substrate 211 to be manufactured, a micro molten pool is formed, and a solidified layer 210 is formed on the radiation path by moving the micro molten pool and sequentially melting and solidifying alloy powder 209. The solidified layer is deposited by depositing the powder with the operation performed along the radiation path, and thus the alloy substrate 211 (corresponding to the alloy substrate A) is produced. A laser beam or an electron beam can be scanned on the alloy substrate 211 without jet-supplying the alloy powder 209, and thus a molten portion can also be formed on the surface layer.

### (Surface treatment step)

For the step for performing a surface treatment on the alloy substrate, that is, the surface treatment step, a method of a coating treatment of forming a coating on the surface of the alloy substrate, or a nitriding or carburizing treatment of diffusing nitrogen or carbon can be preferably used, in terms of improving hardness of the alloy substrate.

### [Coating treatment]

A coating treatment of forming a coating on a surface of an alloy substrate will be described below as an example of a surface treatment. Here, "coating" mentioned in the present specification refers to a member harder than the alloy substrate. Examples of coating compositions (components) include nitrides, carbonitrides, oxynitrides, oxides, and the like. The coating preferably has a thickness of 0.5 µm or greater. Further, it preferably has a thickness of 1.0 µm or greater. Further, it more preferably has a thickness of 2.0 µm or greater. However, the coating is highly likely to peel off when it is excessively thick, and thus it preferably has a thickness of 100.0 µm or less. Further, it preferably has a thickness of 50.0 µm or less. Further, it more preferably has a thickness of 30.0 µm or less. The coating may be formed in the portion at which the coating is in contact with an object, may be a part of the surface of the alloy substrate, or may be the entire alloy substrate.

Although a coating formation method is not particularly limited, for example, a chemical vapor deposition (CVD) method, physical vapor deposition (PVD), or the like can be used as a coating formation method.

In PVD, for example, while an alloy substrate is heated to a temperature in the range of 100°C to 600°C, components of a target used as a raw material whose composition has been adjusted to a desired composition are used to form a coating on a surface of the alloy substrate using an arc ion plating method or a sputtering method. The composition of the target is adjusted to a pure metal or an alloy, nitrogen gas, methane gas, and oxygen gas are introduced during film formation, and thus nitrides, carbonitrides, oxynitrides, oxides, and the like can be coated. Metal components of the target preferably contains, for example, any one of Ti, Cr, Al, and Si. The nitride composition of the coating is, for example, TiN, CrN, TiAlN, CrAlN, TiAlSiN, CrAlSiN, TiCrAlSiN, or the like. In addition, by adjusting the target to carbon, diamond-like-carbon (DLC) can be coated.

In CVD, for example, while an alloy substrate is heated to a temperature in the range of 600°C to 1050°C, raw material gas is used to form a hard coating on the surface of the alloy substrate using the chemical vapor deposition method. If raw material gas composed of gas containing a metal component, nitrogen gas, methane gas, balanced hydrogen gas is used, a coating of nitrides, carbonitrides, oxides, and the like of the metal can be formed. For CVD, there are methods of forming a film at a high temperature (HT) of about 1000°C, and forming a film at a moderate temperature (MT) that is lower than a coating temperature. Each coating may be single-layered or multiple-layered. In addition, PVD and CVD can be combined. A surface with excellent abrasion resistance and sliding properties can be obtained by forming a coating on the surface of the alloy substrate as described above.

### [Nitriding treatment/carburizing treatment]

Next, a nitriding treatment and a carburizing treatment for causing nitrogen to be diffused on the surface of an alloy substrate will be described as another embodiment of a surface treatment. The nitriding treatment and carburizing treatment is to form a diffusion layer by causing nitrogen or carbon to penetrate the surface of the substrate. The diffusion layer preferably has a thickness of 0.5 µm or greater. Further, it preferably has a thickness of 10.0 µm or greater. Further, it more preferably has a thickness of 50.0 µm or greater. Although a method of forming a diffusion layer is not particularly limited, for example, plasma nitriding, gas nitriding, salt bath nitriding, gas carburizing, solid carburizing, gas carburizing, liquid carburizing, vacuum carburizing (vacuum gas carburizing), plasma carburizing (ion carburizing), or the like can be used. A compound layer containing nitrogen or carbon may be formed on the diffusion layer. In addition, an oxynitride layer or a sulfide layer may be formed by introducing oxygen or sulfur during a surface treatment.

In a plasma nitriding treatment, for example, a substrate is heated to 450°C, the surface is purified with a mixed gas of argon and hydrogen, then the gas species is adjusted to a mixed gas of nitrogen and hydrogen, a bias voltage is applied to the substrate to generate plasma around the substrate, and thereby a nitrogen diffusion treatment can be performed. A coating can be formed from the top of the nitride layer using PVD and CVD. When a coating is formed from the top of the nitride layer using PVD and CVD, it is preferable not to form a compound layer on the nitride layer.

Here, it is preferable to perform an aging heat treatment after the additive manufacturing step or before the surface treatment step, that is, between the additive manufacturing step and the surface treatment step. An example of the aging heat treatment is illustrated in FIG. 4. In order to increase the hardness of the alloy substrate, the aging heat treatment in which the alloy substrate 101 is heated so that the temperature thereof is kept in a temperature range in which ultra-fine particles easily increase, for example, in the range of 450°C to lower than 1000°C, is performed. By performing the aging heat treatment at a temperature at which an alloy substrate is used or higher, an alloy substrate that exhibits almost no decrease in hardness when the alloy substrate is used in a temperature range equal to or lower than the above-mentioned temperature can be obtained. The aging heat treatment is preferably performed at a practical temperature or higher on a member required to have abrasion resistance at a high temperature. In addition, a surface treatment is applied in most cases to give abrasion resistance, and the surface treatment temperature is high in most cases. In such a case, the aging heat treatment is preferably performed at the surface treatment temperature or higher. A temperature of the aging heat treatment to increase hardness of a additive manufactured product (alloy substrate) is preferably in the range of 600°C to 950°C, and more preferably in the range of 650°C to 900°C.

The aging heat treatment step may serve as a surface treatment step in which an additive manufactured product (alloy substrate) is held to be surface-treated at a temperature, for example, in the range of 450°C°C to lower than 1000°C, preferably in the range over 500°C to 900°C during the surface treatment step, and the surface treatment step may be performed after the aging heat treatment step. In other words, the surface treatment step can boost hardness. If the surface treatment step serves as the aging heat treatment, the step can be simplified. Although will be described below, the aging heat treatment and the solution treatment may be combined, an alloy substrate that has undergone the aging heat treatment may be surface-treated after the solution treatment, for example, and an alloy substrate that has undergone only the solution treatment may be surface-treated.

It is understood that adhesion of a coating depends on the hardness of a member to be coated. In other words, if an alloy substrate comes to have improved hardness after the aging heat treatment, an alloy member with improved adhesion between the alloy substrate and the coating can be obtained. Since an alloy substrate is coated with a raw material gas in CVD, the reversal property of going back to a complicated shape is great, the entire inner and outer surfaces of the complicated shape obtained from additive manufacturing can be coated, and thus CVD is a preferable coating formation method. In addition, although a substrate with high softening resistance needs to be selected since CVD has a higher film formation temperature than PVD, the alloy member according to the present invention is held in the film formation temperature range of CVD, thus an alloy member with a high hardness can be obtained even when the aging heat treatment is not performed, and thus the coating formation method of CVD is preferable.

The effect of improved strength is exhibited if the aging heat treatment temperature is 450°C or higher, and generation of hexagonal precipitates is mitigated if the temperature is 900°C or lower, and thus ductility can be held. An upper limit value and a lower limit value can be arbitrarily combined. The same applies below. The retention time may be 0.5 hours or longer and 24 hours or shorter. The time is preferably set to 0.5 hours or longer and 8 hours or shorter, and more preferably set to one hour or longer and 8 hours or shorter. The effect of improved strength is obtained if the time is 0.5 hours or longer, and generation of hexagonal precipitates that may cause deterioration in corrosion resistance can be mitigated if the time is 24 hours or shorter. Nanoscale ultra-fine particles with an average particle size of 50 nm or smaller can be generated in a microcell structure to be described below by performing the above-described aging heat treatment, and thus strength can be improved.

Although a cooling step after the aging heat treatment is not particularly limited, there is a possibility of an excessive amount of nanoscale ultra-fine particles being generated if the alloy substrate is held at a temperature around the aging heat treatment temperature for a long period of time, and thus the alloy substrate can be cooled to the room temperature with air cooling, gas cooling, or the like. In addition, FIG. 4 is an example, and the heat treatment pattern can be variously changed. In addition, if the heating rate is set to 5°C/minute or higher in the heating process for the aging heat treatment, for example, the temperature of stay in the intermediate temperature range in which a precipitation amount is difficult to adjust can be preferably shortened. The heating rate is preferably 10°C/minute or higher. Although the upper limit is not particularly limited, it may be about 1000°C/minute or lower in terms of ensuring temperature uniformity of the manufactured product (alloy substrate), particularly, prevention of an overheated part.

The alloy member produced after undergoing the additive manufacturing step and surface treatment step described above has a surface treated layer formed on the surface of the alloy substrate, and thus an alloy member with a hardness of 38 HRC or higher, preferably 40 HRC or higher, and more preferably 45 HRC or higher can be obtained. The alloy member described above is very excellent in hardness and abrasion resistance.

### [Ultra-fine particle]

In addition, ultra-fine particles are generated in a microcell structure with an average diameter of 10 µm or less in the aging heat treatment. The average particle size of the ultra-fine particles is 50 nm or less, which is smaller than that of ultra-small particles included in parent-phase crystal grains to be described below. Although the lower limit of the average particle size is not particularly limited, for example, it is about 2 nm, preferably 3 nm, and more preferably 5 nm. The upper limit thereof is preferably about 30 nm, more preferably 20 nm, and even more preferably 10 nm. If an average particle size of ultra-fine particles is 2 nm or greater and 50 nm or less, hardness can be improved. It is known that, if an average particle size of ultra-fine particles exceeds 50 nm, ductility deteriorates. For a size of ultra-fine particles, an image including ultra-fine particles is acquired by means of a high-magnification observation mechanism represented by transmission electron microscopy and high-resolution scanning electron microscopy, the average of the inscribed circle diameters and the circumscribed circle diameters of the ultra-fine particles is used as the particle size of the ultra-fine particles, and the average of the particle sizes of 20 ultra-fine particles is used as an average particle size.

### [Ultra-fine structure of alloy substrate]

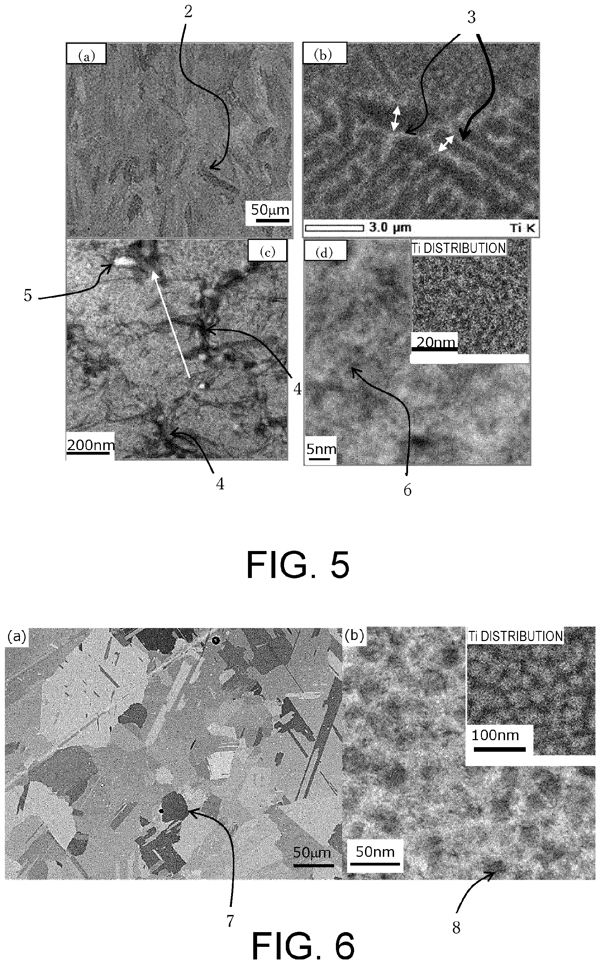

FIG. 5 shows an example of a microstructure of an alloy substrate (aging heat treatment material: M1-AG) that has undergone the aging heat treatment at 650°C for 8 hours with the nominal composition shown in Table 1, in which (a) and (b) are scanning electron microscope images (SEM images) and (c) and (d) are scanning transmissive electron microscope images (STEM images).

The alloy substrate of the present embodiment has a parent-phase structure 2 mainly composed of columnar crystals with a crystal particle size of 20 µm or greater and 150 µm or less (an average crystal particle size of 100 µm or less) as shown in the SEM image of (a) (since it is difficult to distinguish in the drawing, one structure is indicated by a dashed line). The crystal particle size is the average of 10 crystal particles measured by using a cutting method in an SEM image at 500 times magnification. In addition, although not illustrated in the SEM image of (a), a microcell structure with an average diameter of 10 µm or less is formed inside the structure.

It can be said that, for example, the gap indicated by the arrows in the enlarged image of (b) indicates the diameter of the microcell structure. In addition, in the SEM-EDS image of (b), concentration of Ti was confirmed on the boundary 3 of the microcell structure indicated by the white bright portion. In addition, in the high-magnification bright field image of the STEM image of (c), the brighter area indicates the inside of the microcell structure, and dislocations 4 indicated by black lines with higher density than the inside are shown on the boundary 3 of the microstructure. Thus, as the thickened part in which more black stripes were concentrated than the inside of the microstructure was found from the STEM image, it can be identified that there were dislocations with a higher surface density than the inside of the structure. In addition, it was found that precipitates 5 composed of an intermetallic compound were generated on the boundary 3 of another microcell structure. Furthermore, ultra-fine particles 6 with an average particle size of about 3 nm were found in the high-magnification STEM image (d). In addition, although the element mapping image of STEM-EDX of that region is shown at the upper right part of (d), it was found that the ultra-fine particles 6 are particles enriched with Ni and Ti.

On the other hand, FIG. 6 shows an example of a microstructure of an alloy substrate (solution treatment material: M1-ST) that has undergone the solution heat treatment at 1120°C for one hour with the nominal composition shown in Table 1, in which (a) is a scanning electron microscope images (SEM image) and (b) is a scanning transmissive electron microscope image (STEM image).

In addition, the alloy substrate M1 (without the solution heat treatment and aging heat treatment) had a parent-phase crystal structure mainly composed of columnar crystals with a crystal particle size of 20 µm to 150 µm (an average crystal particle size of 100 µm or less) as in (a) of FIG. 5, and a microcell structure with an average diameter of 10 µmor less was formed therein. In addition, M1-S (with the solution heat treatment and without the aging heat treatment) had a parent-phase structure 7 mainly composed of equiaxed crystals with a crystal particle size of 50 µm to 150 µm (an average crystal particle size of 100 µm or less) as shown in (a) of FIG. 6. It was found that the solution heat treatment recrystallized the columnar crystals into equiaxed crystals. In addition, in M1-S, ultra-small particles 8 with an average particle size of 20 to 30 nm were observed in the parent-phase crystal grains as shown in (b) of FIG. 6. Although the element mapping image of STEM-EDX is shown in (b), it was found that the ultra-small particles 8 were particles enriched with Ni and Ti. Only the microcell structure with a dislocation was found in the alloy member M1, but ultra-fine particles with a particle size of 3 nm or greater were not apparently observed.

### [Solution heat treatment]

A retention temperature in the solution heat treatment is assumed to be in the range of 1080°C to 1180°C (1080°C to 1180°C). The temperature range is preferably 1100°C to 1140°C, and more preferably 1110°C to 1130°C. If the temperature reaches 1080°C or higher, precipitation and residue of precipitates of hexagonal crystals that lead to embrittlement are curbed. In addition, if the temperature is 1180°C or lower, defects such as coarsening of crystal particle sizes and partial melting are less likely to occur. The retention time at the highest temperature is 0.5 hours or longer and 24 hours or shorter, and preferably 0.5 hours or longer and 8 hours or shorter, and more preferably one hour or longer and 4 hours or shorter. If the retention time is 0.5 hours or longer, generation of precipitates of hexagonal crystals in the alloy substrate can be mitigated, and if the retention time is 24 hours or shorter, coarsening of crystal particle sizes can be curbed.

In addition, in the heating process for the heat treatment, if the heating rate is sped up, for example, 5°C/minute or higher in the temperature range (e.g., from 800°C to 1080°C) in which precipitates of hexagonal crystals are likely to occur, the amount of precipitates of hexagonal crystals can be preferably reduced to that before the heat treatment. The heating rate is preferably 10°C/minute or higher. Although the upper limit is not particularly limited, it may be about 1000°C/minute in terms of ensuring temperature uniformity of the alloy substrate, particularly, prevention of an overheated part. In the present invention, the above-described heat treatment can also be said to be a quasi-solution heat treatment because the solid solubility limit of the alloy is not apparent and ultra-small particles with an average particle size of 100 nm or smaller are dispersed and precipitated in the alloy member that is the final product. The heat treatment including the above treatment are referred to simply as a solution heat treatment in the present specification.

### [Cooling step]

Next, a cooling step is performed on the alloy substrate after the heat treatment step. In the cooling step, cooling is preferably performed at a cooling rate of 110°C/minute or higher and 2400°C/minute or lower in the temperature range from the retention temperature to 800°C at least in a heat treatment. Here, the cooling rate is preferably 110°C/minute or higher and lower than 600°C/minute, and more preferably 200°C/minute or higher and lower than 600°C/minute. Cooling of this range can be adjusted in gas cooling using an inert gas, for example, nitrogen, argon, helium, or the like. At the cooling rate lower than 110°C/minute (e.g., furnace cooling or air cooling treatment), precipitates of hexagonal crystals are likely to form from grain boundaries, which may cause a problem of deterioration in corrosion resistance. In addition, there are embodiments in which cooling is performed at the cooling rate of 600°C/minute or higher and 2400°C/minute or lower, and more preferably 1000°C/minute or higher and 2000°C/minute or lower. Cooling of this range can be adjusted in liquid cooling using, for example, salt bath, quenching oil, an aqueous polymer solution, or the like. In addition, at a cooling rate exceeding 2400°C/minute (e.g., immersion cooling in a water bath), deformation of the alloy substrate caused by uneven temperature that occurs during rapid cooling may be a problem. In addition, cooling is better to be continued even at a temperature of 800°C or lower. For example, cooling is preferably continuously performed at about the cooling rate in the temperature range from 700°C to room temperature.

In addition, it is preferable to have a microcell structure with an average diameter of 10 µm or less at least in crystal grains of the surface layer, to have on the boundary of the microcell structure, a dislocation of higher surface density than the inside of the structure, and to have ultra-fine particles with an average particle size of 50 nm or less dispersed and precipitated at least inside the microcell structure. Furthermore, Ti is concentrated on the boundary of the parent-phase microcell structure. Ultra-small particles with an average particle size of 100 nm or smaller are dispersed and precipitated in the parent-phase crystal grains inside the member on the inner side of the surface layer.

### [Manufacturing method including remelting/solidification step]

A structure in which the above-described microcell structure and ultra-fine particles coexist is produced by performing the aging heat treatment directly on the solidified structure having the microcell structure as it is. Another embodiment of a method for manufacturing an alloy member taking advantage of this feature will be described below.

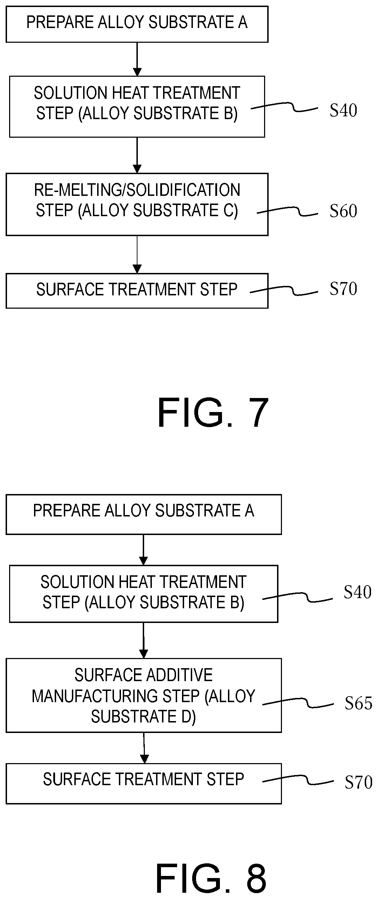

Another embodiment of a method for manufacturing an alloy member may begin with preparing a pre-obtained alloy substrate A. As illustrated in FIG. 7, he alloy substrate A to be used may be obtained after the above-described removal step, or may be manufactured separately in advance. The solution heat treatment to be described below is performed on the alloy substrate A to obtain an alloy substrate B with a parent-phase structure mainly composed of equiaxed crystals. The surface layer of the alloy substrate B is melted and solidified by using laser beams or electron beams to form a new solidified layer. A laser beam or an electron beam can be scanned on the alloy substrate B without jet-supplying alloy powder as described above, and thus a solidified layer can be formed.

A re-melting alloy substrate C is obtained by performing re-melting and solidification step as above. In the re-melting alloy substrate C, a solidified structure including a microcell structure with a diameter of 10 µm or less on the surface layer is formed on the matrix with excellent corrosion resistance and mechanical properties. By performing the aging heat treatment directly on the re-melting alloy substrate C, an alloy substrate with more excellent mechanical properties such as tensile strength and ductility and further improved hardness can be obtained. In addition, the above-described surface treatment may be performed on the alloy member.

### [Manufacturing method including surface layer additive manufacturing step]

In addition, another (second) embodiment will be described. The step can begin with the solution heat treatment and preparation of an alloy substrate B with a parent-phase structure mainly composed of equiaxed crystals as shown in FIG. 8. The alloy substrate B to be used may be obtained after the solution heat treatment step, or may be manufactured separately in advance. A surface layer additive manufacturing step for forming a new solidified layer from melting and solidification is performed on the surface layer by performing the additive manufacturing using a laser beam or electron beam on the alloy substrate B, and thereby a surface layer-added alloy substrate D is obtained. By performing the aging heat treatment directly on the surface layer-added alloy substrate D, an alloy member (a second alloy member) of the alloy substrate with more excellent mechanical properties such as tensile strength and ductility and further improved hardness can be obtained. In addition, the above-described surface treatment may be performed on the alloy member.

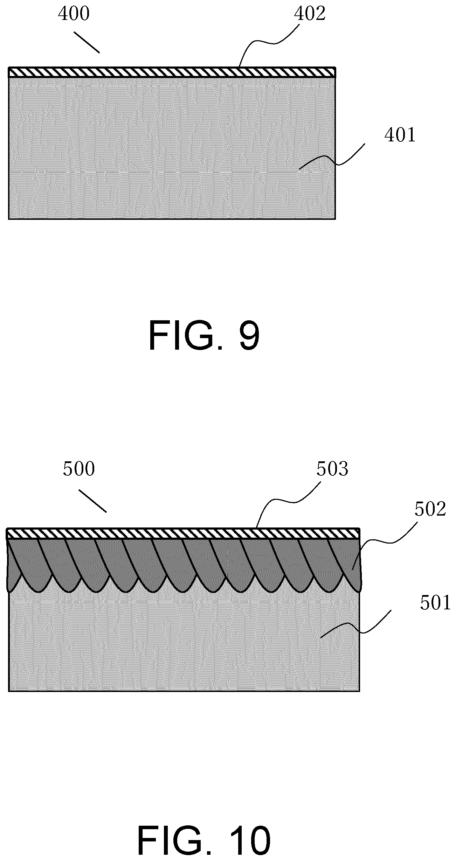

The second alloy member manufactured in the manufacturing method using the above re-melting and solidification step or surface layer additive manufacturing step has the surface layer with improved hardness. In other words, as illustrated in Figs. 9 and 10, an equiaxed crystal structure with excellent toughness and ductility is arranged in the insides 401 and 501 of the alloy member, a configuration in which ultra-fine particles smaller than ultra-small particles contained in the insides 401 and 501 of the alloy member coexist is provided, and a surface treated layer can be provided in top surface layers 402 and 503. With this configuration, an alloy member with more excellent mechanical properties such as tensile strength and ductility and further improved hardness can be obtained as described above.

### <Application and product>

Applications and products using the alloy member of the present invention are arbitrary. Mechanical properties and abrasion resistance according to applications can be gained by appropriately selecting a manufacturing method, such as performing the aging heat treatment on an additive manufactured product or performing the solution heat treatment and aging heat treatment on an additive manufactured product.

Examples of applications include oil well drilling equipment, screws and cylinders of injection molding, turbine wheels of generators, impellers of compressors, valves and joints of chemical plants, heat exchangers, pumps, semiconductor manufacturing equipment and components, and casting molds, forging molds, extrusion molds, press molds, plastic molding molds, etc. In the present invention, such machinery, apparatus, members, molds, components, and the like are collectively called products.

### [Examples]

The present invention will be described in more detail using examples and comparative examples. The present invention is not limited only to the examples.

### (Experiment 1)

### [Production of HEA powder P1]

Raw materials were mixed in the nominal composition shown in Table 1 and alloy powder was manufactured from a molten metal by using the vacuum gas atomization method. Next, the obtained alloy powder was sieved to select powder having a particle size of 10 µm to 53 µm and an average particle size (d50) of about 35 µm, and thus HEA powder P1 was prepared. In addition, the powder was sieved to select powder having a particle size of 53 µm to 106 µm and an average particle size (d50) of about 80 µm, and thus HEA powder P2 was prepared. The reason for selecting the composition of P1 is that it is particularly excellent in mechanical properties such as strength and ductility in a pre-examination by the inventors. The powder with the composition disclosed in, for example, WO 2019/031577 described above can be used.

**[Table 1]**

| Nominal composition of HEA powder P1 (unit: atomic%) | | | | | | |
|---|---|---|---|---|---|---|
| HEA powder | Co | Cr | Fe | Ni | Ti | Mo |
| P1 | 28.0 | 19.7 | 17.6 | 23.4 | 8.9 | 2.4 |

### (Experiment 2)

### [Production of alloy substrate (M1) and improvement of hardness through aging heat treatment]

A powder-based additive manufacturing apparatus (EOS M290 manufactured by EOS Gmbh) shown in FIG. 2 was used for the HEA powder P1 prepared in Experiment 1 for additive manufacturing an alloy substrate M1 (additive manufactured body: a cylindrical material of ϕ20 mm × height 5 mm, the height direction is the laminated direction) by using the SLM method along the procedure of the additive manufacturing step for FIG. 1. The output of laser during additive manufacturing was set to 300 W and the laser scanning rate was set to 1000 mm/sec., and the scanning interval was set to 0.11 mm based on the pre-examination by the inventors. The hardness of the alloy substrate M1 as manufactured in the SLM method was 40.9 HRC. In addition, the thickness of each laminated layer was set to about 0.04 mm. In addition, HEA powder P2 was deposited and manufactured on the upper part of the maraging steel by using a laser beam powder deposition apparatus (Lasertec65 3D manufactured by DMG MORI Co., Ltd.). The output of laser during additive manufacturing was set to 1800 W, the laser scanning rate was set to 1000 mm/sec.. the powder supply amount was set to 14 g/minute based on the pre-examination by the inventors, and thus powder was deposited about 8 mm thick. The hardness of the alloy substrate M1 as manufactured in the LMD method was 38.1 HRC. The material manufactured in the SLM method tended to have a lower hardness than that manufactured in the LMD method.

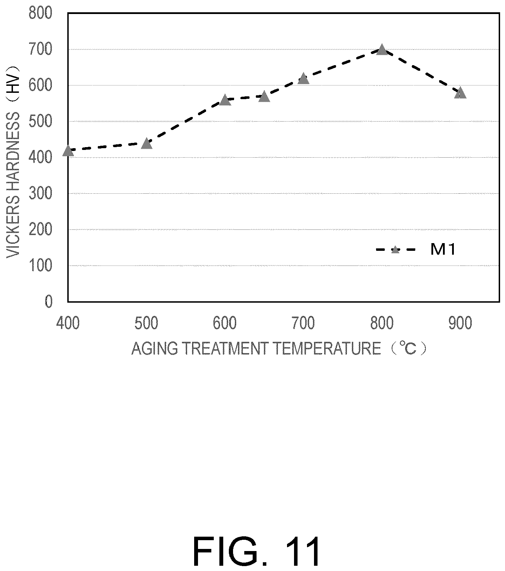

After the additive manufacturing step S30 and the removal step S50, the alloy substrate M1 (corresponding to an alloy substrate A) was obtained. Here, Vickers hardness when the alloy substrate M1 was held at a temperature of 450°C to lower than 1000°C (aging heat treatment) is shown in FIG. 11. By holding the alloy substrate M1 at a temperature in the range of 450°C to lower than 1000°C as shown in FIG. 11, an alloy substrate with suitable Vickers hardness was produced.

In addition, as a result of examining the hardness improvement mechanism, it was found that a microcell structure was generated by using the additive manufacturing method and ultra-fine particles with an average particle size of 50 nm or less that are smaller than ultra-small particles in parent-phase crystal grains as shown in FIG. 5 were generated in the microcell structure due to the aging heat treatment. Here, a dislocation is a linear crystallographic defect within a crystal structure, at which a local change is made in the arrangement of atoms. It was thought that a high hardness was gained by generating nanoscale ultra-fine particles with a highly dislocation density.

### (Experiment 3)

### [Hardness of alloy substrate (M1) with PVD film formation when all kinds of heat treatment were performed]

Next, with respect to an alloy substrate M1, an alloy member obtained by forming a coating through PVD on a surface of the alloy substrate M1 that had undergone all kinds of heat treatment was produced. For the coating step, an arc ion plating-type film forming apparatus was used. This apparatus included an arc evaporation source, a vacuum vessel, and a substrate rotation mechanism. To form an AlCrSin film, an AlCrSi target was set as an arc evaporation source metal. To form a TiN film, a Ti target was set as an arc evaporation source metal. The vacuum vessel was evacuated with a vacuum pump and introduced gas with a supply pump. A bias power source was connected to the alloy member set in the vacuum vessel, and a negative DC bias voltage was applied to the alloy member.

The film formation process was performed as follows. First, the inside of the vacuum chamber was evacuated to set the pressure to 8 × 10-3 Pa or less. Then, the substrate temperature was heated to a set temperature (450°C, 500°C, or 580°C) by using the heater installed in the vacuum vessel, and the vacuum vessel was evacuated. Then, Ar gas was introduced into the vacuum vessel to set the pressure to 0.67 Pa. Then, a current of 20A was supplied to a filament electrode, a bias voltage of -200 V was applied to the alloy substrate, and then Ar bombardment was performed for 4 minutes. Then, the gas inside the vacuum vessel was replaced with nitrogen. The negative bias voltage applied to the substrate, the cathode voltage, and furnace pressure were adjusted for each sample, an arc current of 150 A was supplied to the cathode, and thus a coating of an AlCrSiN composition was applied to a thickness of 15 µm. In addition, a coating of a TiN composition was applied to a thickness of 3.0 µm. The set temperature of the substrate at the time of film formation was changed depending on the film composition, and thus changed to 450°C for the CrAlSiN composition, and 500°C and 580°C for the TiN composition. Then, the substrate was cooled to about 200°C and taken out from the vacuum vessel to produce a sample.

### (Heat treatment conditions)

Heat treatments performed on the alloy substrate M1 were the solution heat treatment, the aging heat treatment, and the aging heat treatment after the solution heat treatment. For conditions for the solution heat treatment, a vacuum furnace was used, the alloy substrate was heated at a heating rate of 10°C/minute and held at 1120°C for one hour, and then cooled by using high pressure nitrogen gas at a set pressure of 0.5 MPa. For conditions for the aging heat treatment, the alloy substrate was held in the atmosphere in a muffle furnace at 800°C for one hour and was cooled to room temperature by furnace cooling. For conditions for the aging heat treatment after the solution treatment, the conditions for the previous period were used in the solution treatment. In the aging treatment thereafter, a vacuum furnace was used for an alloy substrate produced in the SLM method, the alloy substrate was heated at a heating rate of 10°C/minute and held at 700°C for 8 hours, and then cooled by using high pressure nitrogen gas at a set pressure of 0.5 MPa. A vacuum furnace was used for an alloy substrate produced in the LMD method, the alloy substrate was heated at a heating rate of 10°C/minute and held at 700°C for 5 hours, and then cooled by using high pressure nitrogen gas at a set pressure of 0.5 MPa.

For alloy members subjected to the heat treatment and PVD film formation treatment as described above, alloy members produced in the SLM method with no treatment (M1-As Built) were called present invention examples 2, 3, and 4, alloy members produced in the SLM method and subjected to the solution heat treatment (M1-ST) were called present invention examples 7, 8, and 9, alloy members produced in the SLM method and subjected to the aging heat treatment after the solution heat treatment (M1-ST-AG) were called present invention examples 12, 13, and 14, alloy members produced in the SLM method and subjected to the aging heat treatment (M1-AG) were called present invention examples 17, 18, and 19, and alloy members produced in the LMD method and subjected to the aging heat treatment (M1-AG) were called present invention examples 22, 23, and 24. In addition, as related art examples, alloy members with a film of a tempered material of SKD61 of a forged material formed under the same conditions as the conditions for the PVD film formation described above were set as the related art examples 2 to 4. Then, the hardness of each alloy member was evaluated.

### (Hardness measurement)

The Rockwell hardness was measured with a Rockwell hardness tester with a load of 150 kgf and a holding time of 15 seconds at room temperature. The measurement was performed three times, and the average of the values of the three times was recorded. The results are shown in Tables 2 to 5.

As a result, it was found that the Rockwell hardness had improved to the same or higher level regardless of which surface treatment had been performed, compared to that before a surface treatment, excluding the present invention examples 12, 13, 14, 17, and 22. The reason for this is that the surface treatment step exhibited the same effect as the aging treatment.

### (Experiment 4)

### [Hardness of alloy substrate (M1) with CVD film formation when all kinds of heat treatment were performed]

Next, with respect to an alloy substrate M1, an alloy member obtained by forming a coating through CVD on a surface of the alloy substrate M1 that subjected to all kinds of heat treatment was produced. The coating step includes a heating step, a hydrogen cleaning step, a film formation step, and a cooling step.

The film formation process was performed as follows. First, the alloy substrate M1 was set in a furnace, Ar gas was introduced thereto to heat it to 900°C for 2 hours, H2 gas was introduced to hold it for 30 minutes, and thus the M1 alloy surface was cleaned. Next, H2, TiCl4, and N2 gas were introduced to hold the alloy member for about one hour, and thus a coating with a TiN composition was formed at a thickness of 3.0 µm. Finally, the substrate was cooled by introducing Ar gas and taken out from the vacuum vessel to produce a sample.

The conditions for the heat treatment performed on the alloy substrate M1 were set to be the same as described in "Heat treatment conditions" above.

For alloy members subjected to a heat treatment and film formation treatment as described above, an alloy member produced in the SLM method with no treatment (M1-As Built) was called a present invention example 5, an alloy member produced in the SLM method and subjected to the solution heat treatment (M1-ST) was called a present invention example 10, an alloy member produced in the SLM method and subjected to the aging heat treatment after the solution heat treatment (M1-ST-AG) was called a present invention example 15, an alloy member produced in the SLM method and subjected to the aging heat treatment (M1-AG) was called a present invention example 20, and an alloy member produced in the LMD method and subjected to the aging heat treatment (M1-AG) was called a present invention example 25. In addition, an alloy member with a film of SKD61 of a forged material formed under the same conditions as the conditions for the CVD film formation described above was set as a related art example 5. In addition, the hardness of each alloy member was evaluated.

### (Hardness measurement)

The Rockwell hardness was measured with a Rockwell hardness tester with a load of 150 kgf and a holding time of 15 seconds at room temperature. The measurement was performed three times, and the average of the values of the three times was recorded. The results are shown in Tables 2 to 5.

As a result, it was found that the Rockwell hardness had improved to the same or higher level regardless of which surface treatment had been performed, compared to that before a surface treatment, excluding the present invention example 15. The reason for this is that the surface treatment step exhibited the same effect as the aging treatment. Thus, the alloy member that has undergone the CVD process performed at a particularly high temperature was improved in hardness. On the other hand, the alloy member of the related art example 5 did not exhibit as high improvement in hardness as that of the present invention example even though the CVD process was performed thereon.

### (Experiment 5)

### [Hardness of alloy substrate (M1) with nitriding treatment when all kinds of heat treatment were performed]

Next, with respect to an alloy substrate M1, a nitriding treatment was performed on a surface of the alloy substrate M1 subjected to all kinds of heat treatment to form a diffusion layer, and thereby an alloy member was produced. The nitriding treatment step includes a heating step, a surface cleansing step, a film formation step, and a cooling step.

Plasma nitriding was used as the nitriding treatment method. First, the alloy substrate M1 was set in a furnace, and the furnace was filled with argon gas. The substrate was heated to 450°C, the gas type was changed to a mixture of argon and hydrogen, and the surface was cleansed with sputtering of argon for 45 minutes. Then, the gas type was changed to a mixed gas of nitrogen and hydrogen, a bias voltage was applied to the substrate to generate plasma around the substrate, and thereby a nitrogen diffusion treatment was performed for over 10 hours. Then, the furnace was cooled and thereby test pieces were produced.

The conditions for the heat treatment performed on the alloy substrate M1 were set to be the same as described in "Heat treatment conditions" above.

For alloy members subjected to a heat treatment and film formation treatment as described above, an alloy member produced in the SLM method with no treatment (M1-As Built) was called a present invention example 1, an alloy member produced in the SLM method and subjected to the solution heat treatment (M1-ST) was called a present invention example 6, an alloy member produced in the SLM method and subjected to the aging heat treatment after the solution heat treatment (M1-ST-AG) was called a present invention example 11, an alloy member produced in the SLM method and subjected to the aging heat treatment (M1-AG) was called a present invention example 16, and an alloy member produced in the LMD method and subjected to the aging heat treatment (M1-AG) was called a present invention example 21. In addition, as a related art example, an alloy member of SKD61 of a forged material subjected to a nitriding treatment under the same conditions as the conditions for the nitriding treatment described above was set as a related art example 1. In addition, the hardness of each alloy member was evaluated.

### (Hardness measurement)

The Rockwell hardness was measured with a Rockwell hardness tester with a load of 150 kgf and a holding time of 15 seconds at room temperature. The measurement was performed three times, and the average of the values of the three times was recorded. The results are shown in Tables 2 to 5.

As a result, it was found that the Rockwell hardness had improved to the same or higher level regardless of which surface treatment had been performed, compared to that before a surface treatment. Based on the above experiments, it was found that the hardness of the alloy members was improved due to not only the coating treatment of forming a coating on the surface layer but also the nitriding treatment of diffusing nitrogen in the surface layer.

**[Table 2]**

| No. | Detai 1 | AM metho d | Before surface treatmen t | -Nitridin g treatment | -PVD 450°C Film composition : CrAlSiN | -PVD 500°C Film composition : TiN | -PVD 580°C Film composition : TiN | -CVD Film composition : TiN |
|---|---|---|---|---|---|---|---|---|
| Present inventio n example 1 | M1-As built | SLM | 40.9 | 44.3 | | | | |
| Present inventio n example 2 | | SLM | | | 42.6 | | | |
| Present inventio n example 3 | | | | | | 41.8 | | |
| Present inventio n example 4 | | | | | | | 43.4 | |
| Present inventio n example 5 | | | | | | | | 54.8 |
| Present inventio n example 6 | M1ST | SLM | 44.1 | 44.5 | | | | |
| Present inventio n example 7 | | | | | 44.1 | | | |
| Present inventio n example 8 | | | | | | 44.3 | | |
| Present inventio n example 9 | | | | | | | 44.5 | |
| Present inventio n example 10 | | | | | | | | 51.7 |

**[Table 3]**

| | Detai 1 | AM metho d | Before surface treatmen t | Nitriding treatmen t | -PVD 450°C Film composition : CrAlSiN | ' -PVD 500°C Film composition : TiN | -PVD 580°C Film composition : TiN | -CVD Film composition : TiN |
|---|---|---|---|---|---|---|---|---|
| Present inventio n example 11 | M1-ST-AG | SLM | 50.7 | 50.8 | | | | |
| Present inventio n example 12 | | | | | 50.5 | | | |
| Present inventio n example 13 | | | | | | 50.6 | | |
| Present inventio n example 14 | | | | | | | 50.3 | |
| Present inventio n example 15 | | | | | | | | 51.6 |
| Present inventio n example 16 Present inventio n example 17 | M1-AG | SLM | 59.6 | 59.7 | | | | |
| | | | | | 59.4 | | | |
| Present inventio n example 18 | | | | | | 59.6 | | |
| Present inventio n example 19 | | | | | | | 59.9 | |
| Present inventio n example 20 | | | | | | | | 55.6 |

**[Table 4]**

| | Detai l | AM metho d | Before surface treatmen t | Nitriding treatmen t | -PVD 450°C Film composition : CrAlSiN | -PVD 500°C Film composition : TiN | -PVD 580°C Film composition : TiN | -CVD Film composition : TiN |
|---|---|---|---|---|---|---|---|---|
| Present inventio n example 21 | Ml-AG | LMD | 48.0 | 49.0 | | | | |
| Present inventio n example 22 | | | | | 47.8 | | | |
| Present inventio n example 23 | | | | | | 48.6 | | |
| Present inventio n example 24 | | | | | | | 48.4 | |
| Present inventio n example 25 | | | | | | | | 50.0 |

**[Table 5]**

| | Detail | Manufacturi ng method | Before surface treatme nt | -Nitridin g treatment | -PVD 450°C Film compositio n: CrAlSiN | -PVD 500°C Film compositio n: TiN | -PVD 580°C Film compositio n: TiN | -CVD Film compositio n: TiN |
|---|---|---|---|---|---|---|---|---|
| Relate d art exampl e 1 | SKD6 1 | Forging | 46.5 | 46.5 | | | | |
| Relate d art exampl e 2 | | | | | 46.4 | | | |
| Relate d art exampl e 3 | | | | | | 46.3 | | |
| Relate d art exampl e 4 Relate d art exampl e 5 | | | | | | | 46.6 | |
| | | | | | | | | 46.7 |

The embodiments and examples described above are merely description to help understand the present invention, and the present invention is not limited only to the described specific configurations. For example, a part of the configuration of a certain embodiment can be replaced with the configuration of another embodiment, and the configuration of another embodiment can be added to the configuration of a certain embodiment. That is, according to the present invention, a part of the configuration of an embodiment or an example of the present specification can be deleted or replaced with another configuration, or another configuration can be added thereto. By adjusting the above-described embodiments, the alloy member disclosed in the present invention can be applied to corrosion and abrasion resistant components widely used in industrial fields, resource fields, chemical plants, mold members, and the like.

### [Reference Signs List]

2, 7 Parent-phase structure
3 Boundary of Microcell structure
4 Dislocation
5 Precipitates
6 Ultra-fine particles
8 Ultra-small particles
10 Molten metal
20 Alloy powder
100 SLM powder additive manufacturing apparatus
101 Alloy substrate
102 Stage
103 Base plate
104 Powder supply container
105 Alloy powder
106 Recoater
107 Powder bed (layered powder)
108 Laser oscillator
109 Laser beam
110 Galvanometer mirror
111 Unmelted powder recovery container
112 2D slice shaped solidified layer
200 Powder additive manufacturing apparatus
201 Powder supply container
202 Laser head
203 Laser beam or electron beam
204 Table
205 Vice
206 Manufacturing head
207 Base plate
208 Powder supply container
209 Alloy powder
210 Solidified layer
211 Alloy substrate
400 Alloy member
401 Inside of alloy substrate
402 Top surface layer of alloy substrate
500: Alloy member
501 Inside of alloy substrate
502 Surface layer of alloy substrate
503 Top surface layer of alloy substrate
S10 Raw material powder manufacturing step
S30 Additive manufacturing step
S40 Solution heat treatment step
S50 Removal step
S60 Re-melting/solidification step
S65 Surface layer additive manufacturing step
S70 Surface treatment step

## Claims

1. A method for manufacturing an alloy member comprising:
an additive manufacturing step for forming an alloy substrate using an additive manufacturing method using an alloy powder containing each element of Co, Cr, Fe, Ni, and Ti in an amount range of 5 atomic% or more to 35 atomic% or less, and Mo in an amount range of more than 0 atomic% to 8 atomic% or less, with the balance being unavoidable impurities; and
a surface treatment step for performing a surface treatment on the alloy substrate.

2. The method for manufacturing the alloy member according to claim 1, comprising:
an aging heat treatment step for holding the alloy substrate at a temperature in the range of 450°C or more to less than 1000°C between the additive manufacturing step and the surface treatment step.

3. The method for manufacturing the alloy member according to claim 1,
wherein, in the surface treatment step, the alloy substrate is subjected to a surface treatment while being held at a temperature in the range of 450°C or more to less than 1000°C.

4. The method for manufacturing an alloy member according to any one of claims 1 to 3,
wherein, in the additive manufacturing step, a heat source to be used in the additive manufacturing method is a laser beam or an electron beam.

5. An alloy member comprising:
an alloy substrate containing each element of Co, Cr, Fe, Ni, and Ti in an amount range of 5 atomic% or more to 35 atomic% or less, and Mo in an amount range of more than 0 atomic% to 8 atomic% or less, with the balance being unavoidable impurities; and
a surface-treated layer formed on a surface of the alloy substrate,
wherein a Rockwell hardness of the alloy substrate is equal to or higher than 38 HRC.

6. The alloy member according to claim 5, having a microcell structure with an average diameter of 10 µm or less at least in crystal grains of a surface layer, having on a boundary of the microcell structure, a dislocation of higher surface density than an inside of the structure,
wherein ultra-fine particles with an average particle size of 50 nm or less are dispersed and precipitated at least inside the microcell structure.

7. The alloy member according to claim 5 or 6, wherein Ti is concentrated on the boundary of the microcell structure.

8. The alloy member according to any one of claims 5 to 7,
wherein ultra-small particles with an average particle size of 100 nm or smaller are dispersed and precipitated in parent-phase crystal grains inside the member on the inner side of the surface layer.

9. A product using the alloy member according to any one of claims 5 to 8.
